# FASCICULE DE BREVET EUROPEEN

(11) **EP 2 956 874 B1**
(45) Date de publication et mention de la délivrance du brevet: **15.03.2017**
(21) Numéro de dépôt: 14704106.5
(22) Date de dépôt: 05.02.2014
(51) Int. Cl.: G06F 17/50

(54) **DISPOSITIF ET PROCÉDÉ POUR ACCÉLÉRER LA PHASE DE MISE À JOUR D'UN NOYAU DE SIMULATION**
VORRICHTUNG UND VERFAHREN ZUR BESCHLEUNIGUNG DER AKTUALISIERUNGSPHASE EINES SIMULATIONSKERNS
DEVICE AND METHOD FOR ACCELERATING THE UPDATE PHASE OF A SIMULATION KERNEL

(30) Priorité: 15.02.2013 FR 1351322
(43) Date de publication de la demande: 23.12.2015
(73) Titulaire: Commissariat à l'Énergie Atomique et aux Énergies Alternatives, 75015 Paris (FR)
(72) Inventeur: VENTROUX, Nicolas, F-91300 Massy (FR); SASSOLAS, Tanguy, F-75014 Paris (FR)
(74) Mandataire: Hnich-Gasri, Naïma
(86) Numéro de dépôt international: PCT/EP2014/052245
(87) Numéro de publication internationale: WO 2014/124852

(56) Documents cités:
- FR-A1- 2 971 596
- ALESSANDRO CIMATTI ET AL: "Verifying SystemC: A software model checking approach", FORMAL METHODS IN COMPUTER-AIDED DESIGN (FMCAD), 2010, IEEE, 20 octobre 2010 (2010-10-20), pages 51-59, XP031869738, ISBN: 978-1-4577-0734-6
- COMBES P ET AL: "Relaxing Synchronization in a Parallel SystemC Kernel", PARALLEL AND DISTRIBUTED PROCESSING WITH APPLICATIONS, 2008. ISPA '08. INTERNATIONAL SYMPOSIUM ON, IEEE, PISCATAWAY, NJ, USA, 10 décembre 2008 (2008-12-10), pages 180-187, XP032392732, DOI: 10.1109/ISPA.2008.124 ISBN: 978-0-7695-3471-8

## Description

### Domaine technique

La présente invention concerne de manière générale les outils de prototypage pour la simulation et l'exploration des systèmes à concevoir, et en particulier un dispositif et un procédé pour accélérer la phase de mise à jour d'un noyau de simulation.

### Art antérieur et problème technique

Alors que la complexité des semi-conducteurs ne cesse de croître, l'utilisation des circuits intégrés a connu une forte progression dans tous les domaines. Les systèmes sur puce, généralement désigné par l'acronyme « SoC » (System-on-Chip en langue anglo-saxone), sont devenus ainsi des éléments incontournables dans de nombreux produits. La conception de tels systèmes nécessite, entre autre, de valider l'exécution du code applicatif sur la plateforme matérielle avant sa conception finale. Les coûts de la phase de conception et de fabrication étant trop importants pour pouvoir réaliser plusieurs essais, l'intégralité du système doit pouvoir être validée avant sa fabrication, et cela dans les délais les plus courts possibles. Ainsi sont apparus des outils de modélisation haut-niveau capable de modéliser les parties logicielles et matérielles d'un système complexe, et permettant le prototypage logiciel comme l'exploration architecturale.

L'utilisation de telles plateformes logicielles lors de la phase de conception est devenue indispensable. Ces plateformes logicielles permettent de faciliter le développement des logiciels bas-niveaux (pilotes, système d'exploitation...), ou encore de faire de l'exploration architecturale. L'exploration architecturale est une phase d'optimisation qui permet de définir la taille et les caractéristiques des différents éléments appartenant au système, comme la taille ou le type des mémoires caches, ou encore par exemple la taille des liens des réseaux d'interconnexion. Plus récemment, des moyens ont été ajoutés aux outils de prototypage pour étudier la consommation d'énergie, ou par exemple la température. La possibilité de disposer de toutes ces informations très tôt dans le flot de conception offre de très nombreux avantages qui ont un effet direct sur la compétitivité du produit final. Il permet par exemple de faire de meilleurs choix architecturaux afin d'accroître les performances et l'efficacité énergétique, ou plus encore de paralléliser les différentes phases de conception afin de réduire considérablement les temps de conception.

Une grande majorité des outils de prototypage logiciels est basée sur le langage de description matériel SystemC ainsi que sur son extension nommée Transactional Level Modeling (TLM). Ces deux éléments font partis du standard IEEE 1666™-2011. Plus précisément, SystemC est une bibliothèque C/C++ libre d'accès comportant une grammaire spécifique permettant la modélisation de systèmes électroniques logiciels et matériels. SystemC repose également sur un noyau capable d'ordonnancer, de manière coopérative, des processus représentant les différents éléments concurrents d'un système. Les simulations SystemC étant séquentielles, les solutions de prototypage virtuel ne peuvent pas exploiter le parallélisme des machines supportant leur exécution. Les temps de simulation augmentent donc directement avec la complexité des modèles simulés.

Il y a encore quelques années, la conception d'un système passait par la mise en oeuvre d'une solution logicielle de prototypage capable d'exécuter son code applicatif ainsi que de supporter l'exploration architecturale. Un seul et même modèle servait de plateforme unique pour la conception logicielle (driver, logiciel système...) et matérielle. Ces simulateurs intégraient le flot de conception classique garantissant un flot unifié depuis les applications jusqu'au matériel.

Plus récemment, la complexité des systèmes à concevoir est devenue telle que deux plateformes logicielles sont aujourd'hui le plus souvent utilisées. On distingue maintenant les prototypes logiciels, comme simulateur pour le développement applicatif, des prototypes matériels, pour l'exploration, l'analyse et la conception architecturale. Cette séparation est principalement due au fait que les prototypes matériels sont devenus trop lents pour le développement applicatif. Au contraire, une abstraction plus importante du comportement de la plateforme ou des informations temporelles permet de réduire significativement les temps de simulation. Toutefois, une telle approche a ses limites. En effet, la complexité des systèmes étant toujours plus importante, il ne sera pas toujours possible d'améliorer les temps de simulation en réduisant la précision. Par ailleurs, la perte d'information et de précision des modèles utilisés lors du développement du logiciel introduit irrémédiablement des erreurs dans le flot de conception.

L'accélération des simulations SystemC peut se faire à plusieurs niveaux. Tout d'abord, il est possible d'optimiser l'ordonnancement des processus SystemC. Comme par exemple dans :
- N. Savoiu, S.K. Shukla and R.K. Gupta, "Design for synthesis, transformation for simulation: Automatic transformation of threading structures in high-level system models", UC irvine Technical Report, 2001;
- G. Mouchard, D. Gracia Pérez, et O. Temam, "FastSysC: A Fast Simulation Engine," Design, Automation and Test in Europe (DATE), Paris, France, 2004;
- Y.N. Naguib et R.S. Guindi, "Speeding up SystemC simulation through process splitting", Proceedings of the conference on Design, automation and test in Europe, Nice, France: EDA Consortium, 2007, p. 111-116;
- R. Buchmann and A. Greiner, "A Fully Static Scheduling Approach for Fast Cycle Accurate SystemC Simulation of MPSoCs", International Conference on Microelectronics (ICM), Cairo, Egypt, December 2007, pp. 105-108.

Ces solutions proposent de réduire les surcoûts dus aux synchronisations et changements de contexte en analysant les dépendances entre les processus et en effectuant un ordonnancement statique. Toutefois, dans le cas où cette évaluation n'a pas le même comportement en fonction de ses entrées ou des données qu'elle manipule, l'ordre optimal d'évaluation des processus peut être modifié et imposer un ordonnancement statique peut conduire à une perte de performance importante (S. Sirowy, C. Huang and F. Wahid, "Online SystemC Emulation Acceleration", IEEE Design Automation Conference (DAC), Anaheim, USA, June 2010).

D'autres solutions proposent de paralléliser l'évaluation des processus sur des structures distribuées, comme par exemple :
- A. Mello, I. Maia, A. Greiner, and F. Pecheux, "Parallel simulation of SystemC TLM 2.0 compliant MPSoC on SMP workstations", Proceedings of the conference on Design, Automation and Test in Europe (DATE), pages 606-609, 2010;
- P. Ezudheen, P. Chandran, J. Chandra, B.P. Simon, and D. Ravi, "Parallelizing SystemC kernel for fast hardware simulation on SMP machines", IEEE Workshop on Principles of Advanced and Distributed Simulation, (PADS) Lake Placid, New York, USA, June 2009, pp. 80-87;
- V. Galiano, H. Migallón, D. Pérez-Caparrós, and M. Martínez, "Distributing SystemC structures in parallel simulations", Spring Simulation Multiconference, San Diego, USA, 2009, pp 1-8.

Cependant, les solutions proposées se dégradent rapidement avec l'augmentation des communications entre les processus.

Une autre solution connue, décrite dans FR2971596, consiste à accélérer l'exécution du noyau SystemC. Pour cela, un ensemble de moyens matériels sont proposés pour l'accélération de simulations SystemC sur des plateformes multicoeurs. Ces moyens sont utilisés pour accélérer la gestion du temps et des évènements. FR2971596 propose en outre un ordonnancement dynamique des processus sur un ensemble de ressources de calcul. Cette solution offre des résultats intéressants, mais ne permet d'améliorer que la phase d'exécution du noyau SystemC.

Dans d'autres solutions encore, il a été proposé de distribuer plusieurs copies du noyau SystemC sur plusieurs ordinateurs ou serveurs de calcul en utilisant des techniques de communications réseaux déjà largement utilisées dans les calculs parallèles :
- A. Mello, I. Maia, A. Greiner, et F. Pecheux, "Parallel Simulation of SystemC TLM 2.0 Compliant MPSoC on SMP Workstations", IEEE conference on Design, Automation and Test in Europe (DATE), Dresden, Germany, March 2010;
- P. Combes, E. Caron, F. Desprez, B. Chopard, et J. Zory, "Relaxing Synchronization in a Parallel SystemC Kernel", Proceedings of the 2008 IEEE International Symposium on Parallel and Distributed Processing with Applications, IEEE Computer Society, 2008, p. 180-187;
- H. Ziyu, Q. Lei, L. Hongliang, X. Xianghui, and Z. Kun, "A Parallel SystemC Environment: ArchSC", IEEE International Conference on Parallel and Distributed Systems (ICPADS), Shenzhen, China, December 2009;
- B. Chopard, P. Combes, et J. Zory, "A Conservative Approach to SystemC Parallelization", ICCS 2006 Proceedings, V.A. Alexandrov et Dongarra, Éd., Springer-Verlag, 2006, p. 653-660.

Or, dans cette approche, les temps de communication induisent une pénalité temporelle très forte de sorte qu'il faut alors rassembler les processus les plus dépendants sur un même groupe (ou « cluster » en langue anglo-saxonne). L'efficacité d'une telle approche requiert donc d'avoir peu de communications inter-clusters et suppose par conséquent des contraintes fortes de dépendances entre les processus. Ainsi, dans l'article "Parallel Simulation of SystemC TLM 2.0 Compliant MPSoC on SMP Workstations" (IEEE conference on Design, Automation and Test in Europe (DATE), Dresden, Germany, March 2010, de A. Mello, I. Maia, A. Greiner, et F. Pecheux), il est proposé d'expliciter le parallélisme au niveau de l'architecture pour favoriser ensuite son évaluation sur des machines massivement parallèles. Cette solution ne permet pas d'explorer et de simuler n'importe quel type d'architectures.

Dans une autre approche, d'autres supports d'exécution sont utilisés. Une telle solution est décrite par exemple dans l'article suivant: M. Nanjundappa, H.D. Patel, B.A. Jose, et S.K. Shukla, "SCGPSim: A fast SystemC simulator on GPUs", IEEE Design Automation Conference (ASP-DAC), Taipei, Taiwan, January 2010. Dans cet article, il est proposé d'utiliser des processeurs graphiques comme machines parallèles pour accélérer l'exécution de simulations SystemC au niveau RTL. Pour cela, le noyau SystemC est modifié pour rendre concurrent l'évaluation des processus grâce à une double mise en mémoire tampon des variables et des signaux de sortie. Ensuite, chaque processus décrit en SystemC synthétisable est transformé en langage CUDA afin de pouvoir être exécuté sur les unités de calcul du processeur graphique. Toutefois, de telles solutions impliquent des modifications importantes du noyau SystemC non conformes au standard. Elles posent des difficultés pour tracer et mettre au point le simulateur comme pour valider le modèle d'exécution. Par ailleurs, elles imposent des contraintes au niveau de la description des processus SystemC qui doivent être synthétisables. Elles ne supportent donc pas de communications transactionnelles, et le nombre de processus différents pouvant être exécutés en parallèle est limité. Enfin, l'accès à la mémoire globale, nécessaire pour chaque synchronisation entre les processus, est pénalisé d'une latence très importante.

D'autres articles abordent une approche similaire en essayant de porter leur simulateur sur le processeur CELL d'IBM : L. Kaouane, D. Houzet, S. Huet, "SysCellC: SystemC on Cell", IEEE International Conference on Computational Sciences and Its Applications (ICCSA), Le Havre, France, June 2009. Pour cela, des primitives FIFO et les signaux présents dans la librairie SystemC ont été modifiés pour y intégrer de manière abstraite le protocole de communication utilisé dans l'architecture CELL. Ainsi, tous les processus SystemC doivent communiquer entre eux via des FIFO ou des signaux SystemC. Les communications transactionnelles ne sont donc pas supportées. Afin de répartir les processus SystemC sur les différents processeurs secondaires de l'architecture CELL, un outil de partitionnement statique basé sur une étude préliminaire des profils des processus est utilisé. Enfin, afin de limiter les communications avec le processeur principal, une partie du noyau SystemC est distribué entre tous les processeurs secondaires dans le but d'ordonnancer localement les groupes de processus alloués. Par ailleurs, des modifications importantes du simulateur sont effectuées et d'importantes contraintes au niveau de l'architecture réalisée sont imposées. Ces déficiences nuisent considérablement au potentiel d'exploration du domaine de conception de systèmes sur puce et empêchent la mise eu point du simulateur suivant le code généré par le programmeur. Par ailleurs, aucune migration ou allocation dynamique de processus n'est possible. Par conséquent, cette approche statique ne permet pas de prendre en compte des évaluations de processus dont l'exécution est dynamique et peut conduire dans ce cas à une réduction de performance importante.

Une autre approche propose l'utilisation d'éléments matériels spécifiques pour accélérer l'exécution des simulations SystemC, comme décrit dans :
- "Multi-core processor satisfying SystemC syntax", Institute of Computing Technology, Chinese Academy of Sciences, CN101634979, 27 January 2010, China.
- "Event processing unit group of multi-core processor conforming to SystemC grammar", Institute of Computing Technology, Chinese Academy of Sciences, CN101315648, 12 March 2008, China.
- "First-in first-out queue unit set of multi-core processor satisfying SystemC grammar", Institute of Computing Technology, Chinese Academy of Sciences, CN101329702, 24 December 2008, China.
- "Mutual exclusion and semaphore cell block of multi-core processor satisfying SystemC syntax", Institute of Computing Technology, Chinese Academy of Sciences, CN101635006, 27 January 2010, China.
- "SystemC processor to meet the dynamic processes", Institute of Computing Technology, Chinese Academy of Sciences, CN101770362, 7 July 2010, China.
- "Multi-core processor meeting SystemC grammar request and method for acquiring performing code", Institute of Computing Technology, Chinese Academy of Sciences, CN101196826, 11 June 2010, China.

Selon cette approche, des unités matérielles, adjointes à un processeur RISC, capables d'émuler des primitives ou des fonctions SystemC sont utilisées pour accélérer les simulations. Elles supportent par exemple la gestion dynamique de processus (SC_SPAWN), les sémaphores et mutex, les FIFO et la gestion des listes de sensibilité et des évènements. En plus, des unités particulières pour l'échange de données entre processus sont utilisées pour stocker les valeurs des signaux. Là encore, une allocation statique des processus et une modification profonde des simulateurs pour l'utilisation des primitives matérielles sont proposées. Par ailleurs, le nombre limité d'unités associées à chacun des processeurs contraint irrémédiablement les possibilités de modélisation.

Dans une autre approche proposée à des fins pédagogiques, des simulations SystemC sont émulées sur une carte FPGA au niveau RTL, comme décrit dans :
- S. Sirowy, C. Huang and F. Wahid, "Portable SystemC-on-α-Chip ", IEEE CODES+ISSS, Grenoble, France, October 2009
- S. Sirowy, C. Huang and F. Wahid, "Dynamic Acceleration Management for SystemC Emulation ", HIPEAC workshop APRES, Grenoble, France, October 2009
- S. Sirowy, C. Huang and F. Wahid, "Online SystemC Emulation Acceleration", IEEE Design Automation Conference (DAC), Anaheim, USA, June 2010.

Chacune des unités possède une interface définie préalablement et constituée d'un nombre limité d'entrées et sorties. Chacune de ces unités a également accès à des mémoires spécifiques pour stocker ses données, ses instructions et les valeurs des signaux. Par ailleurs, afin de rester indépendant de la plateforme FPGA, la génération d'un exécutable générique et une technique de virtualisation pour son exécution ont été choisies. Ainsi, un moteur d'émulation matériel est ajouté à l'unité d'émulation pour accélérer l'exécution de l'exécutable générique. Dans cette dernière solution, l'utilisation d'une technique de virtualisation apporte de la flexibilité mais alourdit considérablement la complexité du code à exécuter. En outre, le fait d'imposer une interface particulière réduit considérablement l'espace d'exploration et ne convient pas à la conception d'architectures. Par ailleurs, le modèle transactionnel n'est toujours pas supporté et aucun moyen de mise au point ou de trace n'est possible.

Le document de Cimatti et al "Verifying SystemC: A software model checking approach" IEEE FMCAD 2010 décrit un procédé pour la mise à jour des éléments de liaison dans une simulation comprenant une phase d'évaluation comprenant des accès en écriture à des éléments de liaison ou l'on prévoit au préalable pour chaque élément de liaison deux emplacements mémoires d'écriture.

### Définition générale de l'invention

L'invention vient améliorer la situation en proposant un procédé pour accélérer la mise à jour des éléments de liaison dans une simulation d'un système générée selon un langage de description matérielle donné, le procédé comprenant une phase d'évaluation des processus éligibles du système, et la phase d'évaluation comprenant des accès en écriture ou en lecture à des éléments de liaison. Avantageusement, on prévoit au préalable pour chaque élément de liaison deux emplacements mémoires d'écriture, tandis que la phase d'évaluation comprend la mise à jour d'un élément de liaison pour chaque accès en écriture ou en lecture de l'élément de liaison, la mise à jour comprenant les étapes suivantes :
- recevoir un mot de sélection associé à l'élément de liaison ;
- sélectionner l'un des deux emplacements d'écriture associés à l'élément de liaison en fonction de la valeur du mot de sélection reçu pour l'élément de liaison ; et
- mettre à jour la valeur courante de l'élément de liaison à partir de l'emplacement mémoire d'écriture sélectionné.

Les simulations avancent par la succession de phases d'évaluation puis de mise à jour et, lors de ces phases, les lectures aux éléments de liaison retournent une valeur constante appelée valeur courante alors même que des processus écrivent des nouvelles valeurs sur cet élément de liaison. A la fin de la phase de mise à jour la dernière valeur écrite sur un élément de liaison devient la valeur courante de la phase d'évaluation suivante.

Dans une forme de réalisation particulière, le mot de sélection est un bit de parité.

Selon un aspect de l'invention, la mise à jour des éléments de liaison est effectuée en parallèle lors de la phase d'évaluation.

Le procédé peut en outre comprendre des demandes de changement d'état des mots de sélection associés aux éléments de liaison, les demandes étant effectuées en parallèle pendant la phase d'évaluation.

Selon un autre aspect de l'invention, les mots de sélection associés aux éléments de liaison restent constants pendant la phase d'évaluation

Selon une caractéristique de l'invention, pour un accès à un élément de liaison de type lecture, la mise à jour de l'élément de liaison comprend les étapes suivantes :
- recevoir la valeur du mot de sélection pour l'élément de liaison,
- mettre à jour la valeur courante de l'élément de liaison depuis un emplacement mémoire d'écriture déterminé selon la valeur du mot de sélection reçu, et
- retourner la nouvelle valeur courante.

Selon une autre caractéristique de l'invention, pour un accès à un élément de liaison de type écriture, l'étape de mise à jour de l'élément de liaison comprend les étapes suivantes :
- recevoir la valeur du mot de sélection pour l'élément de liaison,
- mettre à jour la valeur courante de l'élément de liaison depuis un emplacement mémoire d'écriture déterminé selon la valeur du mot de sélection reçu,
- écrire la nouvelle valeur de l'élément de liaison dans l'emplacement mémoire d'écriture distinct de l'emplacement mémoire d'écriture déterminé selon la valeur du mot de sélection reçu.

En complément, le procédé peut comprendre une demande de notification delta pour l'évaluation des processus sensibles sur l'élément de liaison si la nouvelle valeur de l'élément de liaison est différente de la valeur courante de l'élément de liaison.

Le procédé peut comprendre en outre l'émission d'une requête de mise à jour du mot de sélection associé à l'élément de liaison.

En particulier, l'étape de mise à jour du mot de sélection peut comprendre une mise à jour du mot de sélection à une valeur opposée à celle du mot de sélection.

Dans une forme de réalisation de l'invention, le langage de description matérielle est SystemC.

Les éléments de liaison peuvent alors comprendre l'un au moins parmi les éléments SystemC suivants : des signaux « sc_signal », des signaux « sc_signal_resolved », des signaux « sc_signal_rv », des mémoires tampons « sc_buffer ».

L'invention propose en outre un dispositif pour accélérer la mise à jour des éléments de liaison dans une simulation d'un système générée selon un langage de description matérielle donné, le dispositif comprenant une phase d'évaluation des processus éligibles du système. Le dispositif comprend une unité d'évaluation pour évaluer des processus, l'évaluation comprenant des accès en écriture ou en lecture d'éléments de liaison. Avantageusement, le dispositif comprend deux emplacements mémoires d'écriture pour chaque élément de liaison, tandis que l'unité d'évaluation comprend, en réponse à un accès en lecture ou en écriture d'un élément de liaison, un appel à une fonction de mise à jour apte à mettre à jour l'élément de liaison, la fonction de mise à jour étant configurée pour :
- recevoir un mot de sélection associé à un élément de liaison à modifier ;
- sélectionner l'un des deux emplacements d'écriture associés à l'élément de liaison en fonction de la valeur du mot de sélection reçu pour l'élément de liaison ; et
- mettre à jour la valeur courante de l'élément de liaison à partir de l'emplacement mémoire d'écriture sélectionné.

Selon une caractéristique de l'invention, le dispositif peut comprendre un module matériel agencé pour délivrer le mot de sélection associé à chaque élément de liaison et pour mettre à jour les mots de sélection.

L'invention permet ainsi d'accélérer les simulations de manière telle que les prototypes virtuels puissent garder une précision importante, tout en étant suffisamment rapide pour le développement applicatif, l'exploration d'architecture ou la vérification fonctionnelle. L'invention contribue également à unifier les prototypes virtuels logiciels et matériels. Il en résulte une réduction des temps de conception et donc des coûts de développements.

L'invention permet en outre de diminuer le temps passé dans le noyau SystemC, ce qui a pour effet de réduire le surcoût dû à l'exécution séquentielle du noyau SystemC. Par ailleurs, l'invention permet de réduire la partie non parallélisable afin de maximiser le gain obtenu par la parallélisation.

Plus généralement, l'invention permet d'accélérer les simulations SystemC aussi bien pour les prototypes virtuels matériels que logiciels.

### Brève description des dessins

D'autres caractéristiques et avantages de l'invention apparaîtront à l'aide de la description qui suit et des figures des dessins annexés dans lesquels:
- la figure 1 représente l'architecture logicielle de la librairie SystemC ;
- la figure 2A représente le procédé d'ordonnancement classique du noyau SystemC ;
- la figure 2B représente le procédé d'ordonnancement du noyau SystemC, selon l'invention ;
- la figure 3 est un diagramme de fonctionnement du noyau de simulation SystemC, selon une forme de réalisation de l'invention ;
- la figure 4 est un organigramme représentant les différentes étapes mises en oeuvre pour mettre à jour un élément de liaison SystemC lors de l'évaluation du processus impliquant une lecture sur l'élément de liaison SystemC ;
- la figure 5 est un organigramme représentant les différentes étapes mises en oeuvre pour mettre à jour un élément de liaison SystemC lors de l'évaluation du processus impliquant une écriture sur l'élément de liaison SystemC; et
- la figure 6 représente la structure du module matériel de mise à jour, selon une forme de réalisation de l'invention.

Les dessins et les annexes à la description comprennent, pour l'essentiel, des éléments de caractère certain. Ils pourront donc non seulement servir à mieux faire comprendre la description, mais aussi contribuer à la définition de l'invention, le cas échéant.

La référence à certaines entités logicielles dans la description impose certaines conventions de notation. En particulier, une expression en italique et/ou des guillemets seront utilisés dans la description ci-après pour identifier un élément de la bibliothèque SystemC, le nom d'un élément structurel SystemC, ou encore des éléments logiciels utilisés par l'invention.

### Description détaillée

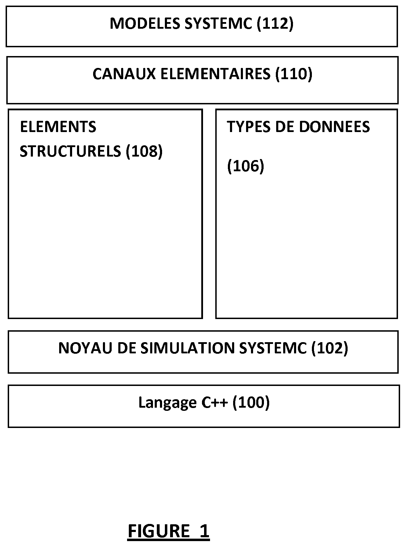

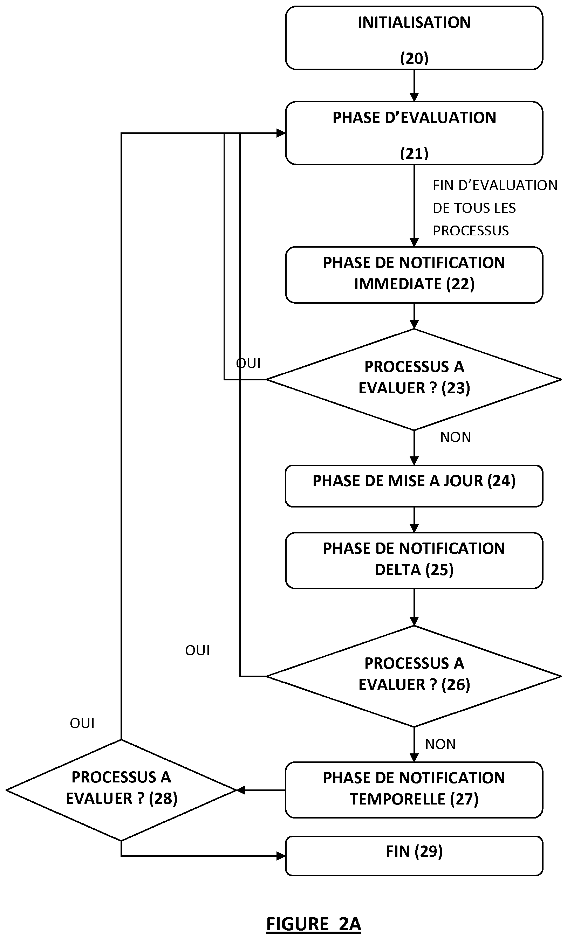

Bien que le lecteur soit supposé familier de l'environnement SystemC, certaines notions sont rappelées ci-après en relation avec la figure 1 et la figure 2A pour faciliter la compréhension de la présente invention.

La figure 1 représente l'architecture logicielle de la librairie SystemC. Cette architecture est organisée en couches. La couche 100 correspond à la couche C++ qui représente la technologie de base sur laquelle repose l'implémentation de SystemC. La couche 102 représente le noyau de simulation SystemC. Le noyau SystemC est basé sur un ordonnancement coopératif et la notion de cycle « delta » pour modéliser la concurrence entre les éléments constituants le simulateur. La couche 106 représente les types de données. Ces types de données incluent tant les types liés à la programmation logicielle que les types liés à la description du matériel.

La couche 108 représente la structure utilisée dans SystemC pour décrire le système matériel. La bibliothèque SystemC présente un ensemble de classes et méthodes pour la modélisation de matériel et la description de comportements au niveau système. Avec le langage de description matérielle SystemC, un système matériel est représenté comme une hiérarchie d'objets comprenant des modules imbriqués et/ou des processus. Les modules communiquent entre eux par des canaux. L'élément le plus haut de la hiérarchie d'un système complet est la fonction SystemC « *sc_main* ». Dans la fonction *sc_main*, les modules sont créés et connectés ensemble, la simulation est ensuite lancée. Le programme est enfin compilé, ce qui génère un exécutable représentant le comportement du système.

Les modules sont les composants de plus haut niveau dans la hiérarchie SystemC. Un module peut contenir des ports qui permettent de communiquer avec d'autres modules et indirectement avec les processus qui décrivent la fonctionnalité du module. Les ports représentent les points d'entrée/sortie des modules. Un module peut contenir d'autres modules.

La couche 110 représente les canaux élémentaires. Les canaux sont les moyens de communication entre les modules. La librairie SystemC comprend trois type de canaux : les signaux (*sc_signal*, *sc_signal_resolved*, *sc_signal_rv*), les mémoires tampon désignées par le terme anglo-saxon « buffers » (*sc_*»*buffer*») et les FIFO (*sc_fifo*). Les mutex (*sc_mutex*) et les sémaphores (*sc_semaphore*) sont quant-à-eux des moyens de synchronisation pour les canaux. Ces canaux peuvent être utilisés individuellement ou peuvent être combinés pour créer des mécanismes de communication plus complexes. Les signaux SystemC représentent les fils du système matériel. A l'instanciation d'un canal, le type de données transportées doit être spécifié (e.g. *sc_bit*, etc.). Les canaux sont utilisés à l'intérieur d'un module pour la communication entre deux processus, ou encore entre modules par l'intermédiaire d'un port du module.

Les processus décrivent une fonctionnalité, un comportement du système. Les processus dans les modules peuvent accéder aux canaux à travers les ports des modules. Le programme principal définit quant à lui la déclaration du sommet de la hiérarchie des modules, et d'autres paramètres tels que la résolution temporelle. Le moteur de simulation SystemC peut appeler ou déclencher un processus sur certains événements particuliers. Les événements qui déclenchent un processus donné sont ceux qui sont définis dans la liste de sensibilité de ces processus. Un processus dispose d'une liste de sensibilité décrivant les événements auxquels il doit réagir. Les processus accèdent aux canaux extérieurs par l'intermédiaire des ports de leur module.

Un événement est un objet de la classe *sc_event* qui n'a ni durée, ni valeur. Une notification indique la modification d'un évènement. Chaque événement garde une liste des processus qui lui sont sensibles. Lorsqu'un événement est notifié, il indique à l'ordonnanceur SystemC les processus à exécuter lors de la prochaine phase d'évaluation. Dans systemC, une occurrence d'évènement peut être notifiée de trois manières différentes à l'ordonnanceur :
- immédiatement, auquel cas on parle de « notification immédiate » ;
- après un délai nul, auquel cas on parle de « notification delta » ;
- ou, après un délai non nul, auquel cas on parle de « notification temporelle ».

Dans la suite de la description, les termes « processus », « port », « canal », « signal », « buffer » seront utilisés en référence aux éléments SystemC correspondants comme décrit ci-avant.

La couche 112 représente le modèle créé au moyen des éléments de la bibliothèque SystemC. Un modèle écrit en SystemC est un programme C++ qui doit être compilé afin de générer un prototype virtuel.

La figure 2A représente le procédé d'ordonnancement du noyau SystemC classique (couche 102). Le noyau SystemC comporte un ordonnanceur chargé de contrôler le temps, l'ordre d'exécution des processus et les notifications des événements. L'ordre d'exécution des processus est indéterminé mais déterministe. Le noyau SystemC, selon l'état de la technique, comporte cinq phases principales et séquentielles : la phase d'évaluation des processus SystemC (21), la phase de notification immédiate (22), la phase de mise à jour (24), la phase de notification delta (25) et la phase de notification temporelle (27). Les étapes de 21 à 26 forment un delta-cycle. Les étapes 21 à 28 forment un cycle de simulation.

Après l'initialisation et l'élaboration du simulateur (phase 20), tous les processus SystemC sont exécutés dans un ordre quelconque lors de la phase d'évaluation 21. Durant cette phase d'évaluation, tous les processus présents dans une file d'attente sont évalués. Chacun des processus peut écrire sur des canaux, notifier un évènement pour réveiller d'autres processus dépendants (notification immédiate) ou générer un évènement temporel (notification temporelle). Une notification immédiate a pour effet de positionner les processus sensibles dans la liste d'attente lors de la phase de notification immédiate 22. Ainsi, si après la phase d'évaluation et de notification immédiate, la file d'attente de processus à évaluer (23) n'est pas vide, la phase d'évaluation est de nouveau relancée.

Lorsqu'enfin la file d'attente 23 est vide, la phase de mise-à-jour 24 est exécutée. Cette phase consiste à mettre à jour tous les éléments de liaison SystemC (par exemple, signaux ou « buffers » systemC) qui ont été modifiés pendant les différentes phases d'évaluation successives. Lorsqu'un élément de liaison est mis à jour et que la nouvelle valeur est différente de la précédente, une notification delta est générée.

Dans la présente description, l'expression « éléments de liaison » est utilisée pour désigner les primitives génériques de la grammaire du langage de description matérielle permettant de modéliser les communications point-à-point temporelles ou non-temporelles, comme par exemple les signaux (tels que « sc_signal », « sc_signal_resolved », « sc_signal_rv »), ou les « buffers » (« sc_buffer ») dans le langage de description matérielle SystemC.

A la fin de la phase de mise-à-jour 24, la phase de notification delta 25 commence. Elle consiste à mettre tous les processus sensibles aux évènements liés aux notifications delta dans la file d'attente de processus à évaluer. Typiquement, l'écriture d'un élément de liaison SystemC (e.g. signal ou « buffer ») génère ce type de notification et tous les processus sensibles à cet élément de liaison seront évalués par la suite.

Si la file d'attente est non vide (26), la phase d'évaluation est alors relancée et toutes les autres phases qui en découlent. Ces étapes sont réitérées jusqu'à ce que la file d'attente soit vide après la phase de notification delta. Enfin, la phase de notification temporelle 27 a lieu. Elle consiste à demander l'évaluation de processus sensibles sur des évènements temporels, ainsi qu'à mettre à jour le pas de simulation. De manière générale, la simulation SystemC s'arrête (29) lorsque le pas de simulation atteint le temps de simulation demandé initialement.

La phase de mise à jour classique du noyau SystemC permet d'exprimer la concurrence à son niveau le plus précis. Comme dans tout langage de description matérielle, il est important que les états des éléments de liaison SystemC (e.g. signaux, « buffers ») ne soient mis à jour qu'à la fin de l'évaluation. En effet, tous les processus sont évalués séquentiellement. Cette solution garantit qu'une lecture d'un élément de liaison SystemC modifié retournera la valeur courante et non pas la nouvelle valeur, comme ce qui se passerait dans des modules réellement concurrents. Ainsi, dans le procédé SystemC classique de mise à jour des éléments de liaison SystemC, chaque élément de liaison SystemC a deux emplacements mémoires : un emplacement pour la valeur courante et un emplacement pour la nouvelle valeur.

Lors de l'évaluation d'un processus sensible impliquant une écriture sur un élément de liaison SystemC (par exemple un signal ou un «buffer» SystemC), ce même élément de liaison SystemC place la nouvelle valeur dans le deuxième emplacement mémoire. Une demande de mise à jour est ensuite effectuée via l'appel à une fonction appelée « *request_update()* ». De même, lorsqu'une écriture ou une lecture a lieu sur une FIFO, une demande de mise à jour est effectuée.

Ce n'est que lorsque les phases d'évaluation et de notification immédiate sont terminées (i.e. la file d'attente de processus à évaluer est vide) que la phase de mise à jour peut être exécutée. La fonction de mise à jour « *update()* » pour chaque canal ayant fait un appel à *request_update()* est alors appelée. Pour les éléments de liaison SystemC de type signal ou « buffer », une recopie du deuxième emplacement mémoire est effectuée vers le premier emplacement mémoire, ce qui a pour effet d'écrire la nouvelle valeur dans la valeur courante. Lorsque la nouvelle valeur est différente de la valeur courante, une notification delta est demandée. Pour les canaux de type FIFO, s'il y a eu une lecture ou une écriture, une notification delta est demandée. Une notification de changement de valeur via un membre du canal de type « *sc_event* » est également réalisée.

Enfin, après la fin de la phase de mise à jour, la phase de notification delta est exécutée. Pour chaque notification delta, à partir de l'évènement de type « *sc_event* », les processus sensibles sur ces canaux sont retrouvés. Cela a pour effet de mettre dans la liste d'attente de processus à évaluer tous les processus sensibles sur les évènements notifiés lors de la phase de mise à jour. Ainsi, tous les processus sensibles sur les canaux modifiés seront appelés lors de la prochaine phase d'évaluation.

Toutefois, un tel procédé de mise à jour peut difficilement être parallélisé ou accéléré.

En cherchant à améliorer les performances du noyau de simulation SystemC, les inventeurs ont constaté en particulier que la phase de mise-à-jour classique du noyau SystemC avait un impact négatif sur les performances des simulations SystemC.

L'invention propose un dispositif et un procédé permettant d'accélérer la phase de mise à jour du noyau SystemC. A cet effet, l'invention modifie la phase d'évaluation 21 et la phase de mise à jour 24 de l'algorithme d'ordonnancement classique du noyau SystemC (couche 102).

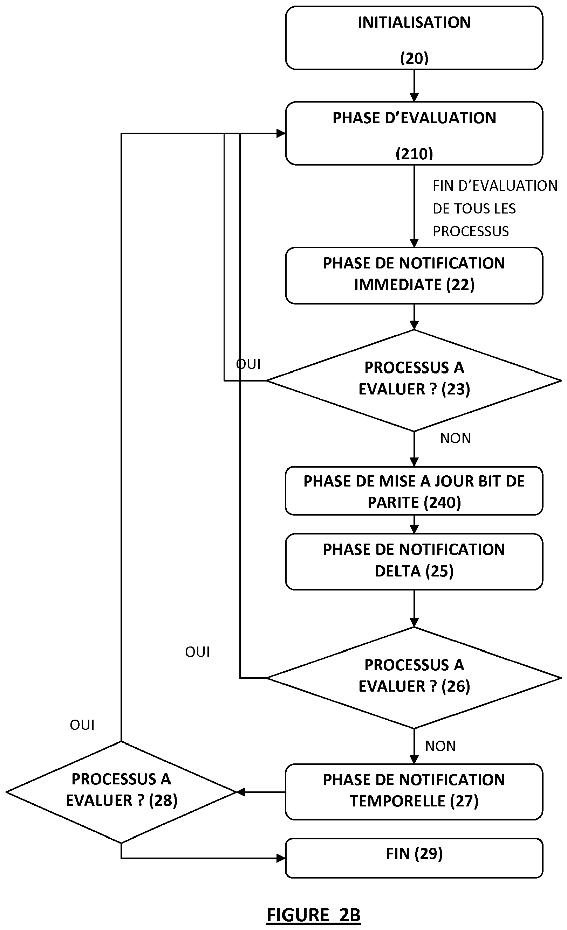

La figure 2B représente le procédé d'ordonnancement du noyau SystemC, selon les formes de réalisation de l'invention.

Selon une caractéristique avantageuse de l'invention, pour chaque élément de liaison SystemC (e.g. signaux ou «buffers » SystemC), deux emplacements mémoire d'écriture, (également appelés ci-après tampons d'écriture) sont utilisés pour l'écriture de la nouvelle valeur dont la sélection est effectuée en fonction d'un mot de sélection (par exemple un bit de parité). Ainsi, l'écriture de la nouvelle valeur peut se faire vers deux tampons d'écriture distincts, ce qui offre des avantages significatifs par rapport à l'approche classique de la librairie SystemC qui utilise un seul tampon d'écriture.

Pour faciliter la compréhension de l'invention, la suite de la description sera faite en référence à un élément de liaison SystemC de type signal et à un mot de sélection de type bit de parité, à titre d'exemple non limitatif.

Dans la figure 2B, des références numériques identiques à celles de la figure 2A sont utilisées pour désigner certaines étapes similaires.

Après l'initialisation et l'élaboration du simulateur (phase 20), les processus SystemC sont exécutés dans un ordre quelconque lors de la phase d'évaluation 210. Durant cette phase d'évaluation, tous les processus présents dans une file d'attente sont évalués. Selon l'invention, la phase d'évaluation 210 inclut une partie de la phase de mise à jour des signaux. Ainsi, avant chaque lecture d'un signal ou écriture sur un signal, la mise à jour du signal est effectuée. Avantageusement, la valeur courante du signal est mise à jour pendant la phase d'évaluation 210 à partir de l'un des deux tampons d'écriture en fonction de la valeur du bit de parité. Enfin, si une écriture a lieu, le tampon d'écriture qui est choisi pour écrire la nouvelle valeur est celui qui n'a pas été utilisé lors de la lecture.

La sélection de l'un des deux tampons est réalisée selon l'invention grâce à un bit de parité, associé à chaque signal. Dans une forme de réalisation préférée de l'invention, un bit de parité unique est associé individuellement à chaque signal. Selon la valeur du bit de parité associé à un signal donné, l'un des deux tampons d'écriture est sélectionné pour écrire la nouvelle valeur, tandis que l'autre tampon d'écriture sera sélectionné pour lire la nouvelle valeur obtenue lors des précédentes phases d'évaluation après avoir effectué la phase de mise à jour afin de mettre à jour la valeur courante. Dans une forme de réalisation avantageuse, la valeur du bit de parité reste constante jusqu'à ce que la phase de mise à jour soit exécutée. En complément, lorsque la nouvelle valeur est différente de la valeur courante, une notification delta peut être demandée au moyen d'une requête de mise à jour effectuée par appel de la fonction *request_update()*.

Lorsque la file d'attente est vide (23) après l'exécution de la phase de notification immédiate (22), une autre partie de la phase de mise-à-jour est exécutée 240. Dans cette étape 240, les bits de parité peuvent être modifiés pour chacun des signaux pour lesquels une demande de mise à jour « request_update() » a été reçue.

L'utilisation de deux tampons d'écriture permet ainsi de garantir un fonctionnement conforme, et d'exprimer la concurrence à son niveau le plus précis, tout en permettant de paralléliser partiellement de la phase de mise à jour. Alors que la phase de mise à jour classique est séquentielle et constitue un surcoût temporel important, la possibilité de paralléliser la phase de mise à jour selon l'invention permet une réduction significative de la durée d'ordonnancement et donc des temps de simulation.

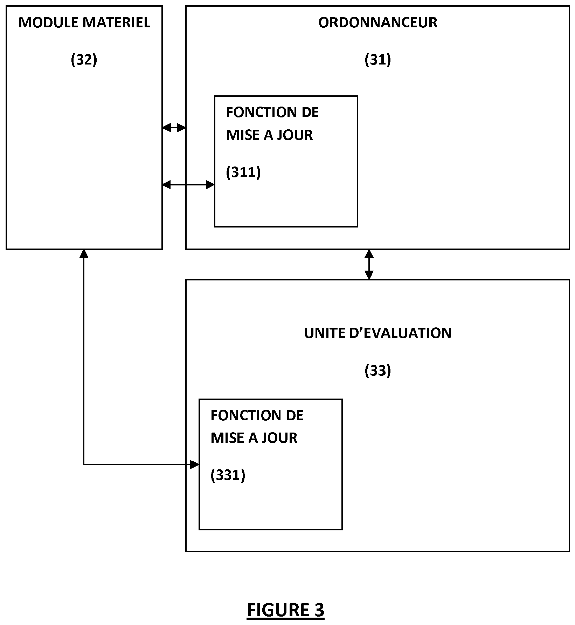

La figure 3 représente un dispositif de simulation 3 selon une forme de réalisation de l'invention.

Le dispositif de simulation 3 exécute la simulation d'un système décrit en SystemC. Il comprend un ordonnanceur 31 configuré pour contrôler l'évaluation des processus, ainsi que les phases d'évaluation 210 et de mise à jour 240 selon l'invention. Le dispositif de simulation comprend en outre une unité d'évaluation des processus 33 qui évalue les processus éligibles sélectionnés par l'ordonnanceur 31 et une fonction de mise à jour des signaux répartie entre une première fonction de mise à jour 311 dans l'ordonnanceur 31 et une deuxième fonction de mise à jour 331 dans l'unité d'évaluation 33.

Sur la figure 3, la fonction de mise à jour 311 est directement intégrée dans l'ordonnanceur 31. En variante, elle peut être séparée de l'ordonnanceur 31.

Le dispositif de simulation 3 selon l'invention réalise une première étape de mise à jour pendant la phase d'évaluation lors d'une écriture sur un signal. Cette première étape consiste à positionner dans l'un des tampons d'écriture la future valeur à utiliser lors de la phase d'évaluation qui aura lieu après la phase de mise à jour. Une deuxième étape de mise à jour est réalisée par un module matériel de mise à jour 32. La dernière étape est réalisée lors de la phase d'évaluation ayant lieu après la phase de mise à jour: lors d'un accès en écriture ou en lecture, la mise à jour finale est effectuée. Ces trois étapes sont ainsi combinées pour réaliser une mise à jour complète. Selon une caractéristique avantageuse de l'invention, le bit de parité du signal est utilisé pour réaliser une telle combinaison.

Selon une caractéristique de l'invention, l'ordonnanceur 31 et les fonctions de mise à jour 311 et 331 interagissent avec le module matériel de mise à jour 32 (également désignée ci-après par « module matériel »). Le module matériel 32 est agencé pour associer un bit de parité à chaque signal SystemC et pour mettre à jour les bits de parité. Dans une forme de réalisation particulière de l'invention, la mise à jour d'un bit de parité consiste à inverser sa valeur : ainsi, si le bit est pair, après sa mise à jour il devient impair, et inversement, si le bit est impair, après sa mise à jour il devient pair.

L'ordonnanceur 31 est configuré pour initialiser le module matériel 32 lors de l'étape d'initialisation 20 et pour demander la mise à jour des bits de parité lors de la phase de mise à jour exécutée par la première fonction de mise à jour 311. La deuxième fonction de mise à jour 331 utilise ce bit de parité pour lire ou écrire un signal. Selon la valeur du bit de parité, le premier tampon d'écriture ou deuxième tampon d'écriture peut être sélectionné.

Dans les réalisations existantes, le seul parallélisme potentiel de SystemC réside dans la phase d'évaluation des processus 210 car tous les processus sont indépendants et peuvent être exécutés de manière désordonnés et concurrents. L'invention permet avantageusement de paralléliser la phase d'évaluation 210 et d'y intégrer une partie de la phase de mise à jour 240. L'utilisation de deux tampons d'écriture permet l'exécution parallèle de la phase de mise à jour 240 en vue d'accélérer les simulations SystemC. Il garantit notamment que pendant la phase d'évaluation 210 les nouvelles valeurs écrites ne modifient pas les valeurs courantes, ce qui est essentiel pour la modélisation de la concurrence.

L'invention repose ainsi sur une solution hybride de mise à jour pouvant faire intervenir des éléments logiciels (la première et la deuxième fonction de mise à jour 311 et 331) et des éléments matériels (module matériel 32) pour accélérer la phase de mise à jour du noyau SystemC, sur la base d'un mécanisme de parité et de deux tampons d'écriture. Selon l'invention, la deuxième fonction de mise à jour 331 intègre la partie de la phase de mise à jour qui peut être parallélisée, la première fonction de mise à jour 311 intègre l'initialisation du module matériel, tandis que le module matériel 32 accélère la partie de la mise à jour qui ne peut pas être traitée en parallèle.

Dans le mode de réalisation représenté sur la figure 3, le module matériel 32 est séparé de l'ordonnanceur 31. En variante, le module matériel 32 peut être intégré dans l'ordonnanceur 31 ou évalué de manière logicielle. Il est à noter que dans la forme de réalisation où le module 32 est séparé de l'ordonnanceur 31, une meilleure accélération a été constatée.

Lors de l'initialisation de chaque signal («étape 20 » de la figure 2B), la requête de mise à jour de l'identifiant du signal « *get_update_signal_id()*» est envoyée au module matériel 32 par l'ordonnanceur 31. En réponse à cette requête « *get_update_signal_id()* », le module matériel 32 retourne un identifiant unique désigné ci-après par *m_signal_id*. Cet identifiant est alors associé à l'objet SystemC tout au long de la simulation. Selon la présente invention, cet identifiant est utilisé par la deuxième fonction de mise à jour 331 pour dialoguer avec le module matériel 32.

Le module matériel 32, selon l'invention, interagit avec les fonctions de mise à jour 311 et 331 selon au moins quatre types de requêtes :
- en réponse à la réception d'une requête, notée « *get_update_signal_id()* », pour l'initialisation de l'identifiant d'un signal donné, le module matériel 32 détermine l'identifiant unique du signal et le retourne à la première fonction de mise à jour 311 ;
- en réponse à la réception d'une requête, notée « *get_signal_parity()* », pour fournir le bit de parité d'un signal donné, le module matériel de mise à jour 32 détermine le bit de parité dudit signal et le retourne à la deuxième fonction de mise à jour 331 ;
- en réponse à la réception d'une requête, notée « *push_update_request()* », pour la demande de mise à jour du bit de parité d'un signal donné, le module matériel de mise à jour 32 sauvegarde la demande de mise à jour de la parité dudit signal ; et
- en réponse à la réception d'une requête, notée « *update()* », pour la mise à jour des bits de parités, le module matériel 32 met à jour les bits de parités de tous les signaux ayant reçus une demande de mise à jour.

Chaque signal dispose d'une variable pour stocker sa valeur courante notée *« m_value »*. Cette valeur peut être lue ou écrite par un processus lors de la phase d'évaluation 210. Selon la présente invention, chaque signal SystemC est par ailleurs associé à deux tampons d'écriture, un premier tampon d'écriture qui sera désigné ci-après *m_next value_even* et un deuxième tampon d'écriture qui sera désigné ci-après *m_next_value_odd*. En fonction de la valeur du bit de parité courant que retourne le module matériel 32 pour le signal donné, l'un des deux tampons est sélectionné pour mettre à jour ou lire la valeur du signal lors de l'évaluation d'un processus.

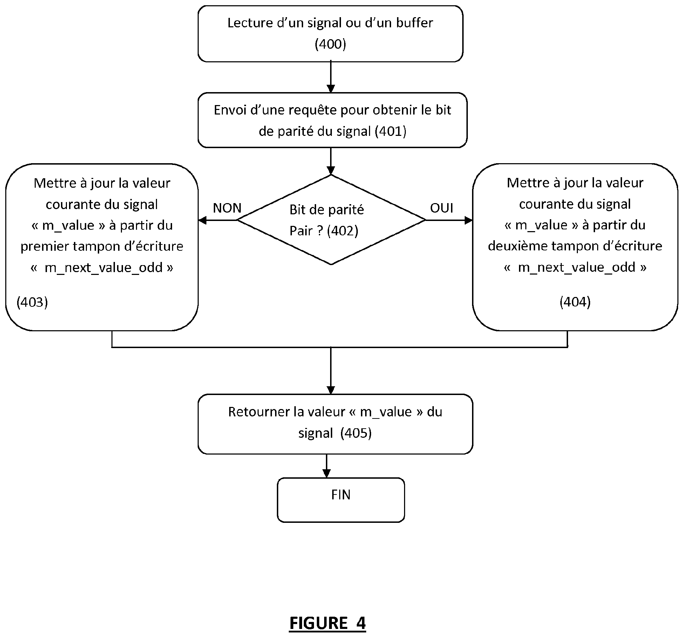

La figure 4 est un organigramme représentant les différentes étapes mises en oeuvre par la deuxième fonction de mise à jour 331 pour mettre à jour un signal lors de l'évaluation d'un processus qui lit le signal.

La lecture d'un signal commence par la mise à jour de sa valeur courante. Selon l'invention, la mise à jour des signaux est faite lors de la phase d'évaluation 210, notamment au moyen de la fonction de mise à jour 331, ce qui permet la parallélisation de la phase de mise à jour. Une fois la mise à jour effectuée, la valeur courante peut alors être retournée.

Lors de la lecture (étape 400) de la valeur courante *« m_value »* d'un signal pouvant intervenir lors de la phase d'évaluation 210, une première partie de la phase de mise à jour a tout d'abord lieu, dans les étapes 401 à 405.

Plus précisément, à l'étape 401, une requête « *get_signal_parity()* » est envoyée au module matériel 32 pour obtenir le bit de parité courant du signal. L'identifiant du signal reçu dans la phase d'initialisation 20 est passé en paramètre de cette requête et est utilisé par le module matériel de mise à jour 32 pour retrouver l'information.

A l'étape 402, il est déterminé si le bit de parité courant retourné par le module matériel 32 est pair. Si le bit de parité courant est pair, à l'étape 403, la valeur courante *m_value* du signal est mise à jour depuis la valeur *m_next value_even* du premier tampon d'écriture (également désigné ci-après par « tampon pair ») : « *m_value* = *m_next_value_even »*. Sinon, si le bit de parité courant est impair, à l'étape 404, la valeur courante du signal est mise à jour à partir de la valeur *m_next_value_odd* du deuxième tampon d'écriture (également désigné ci-après par « tampon impair ») : « *m_value* = *m_next_value_odd »*.

A l'étape 405, la valeur courante du signal est retournée selon le standard SystemC.

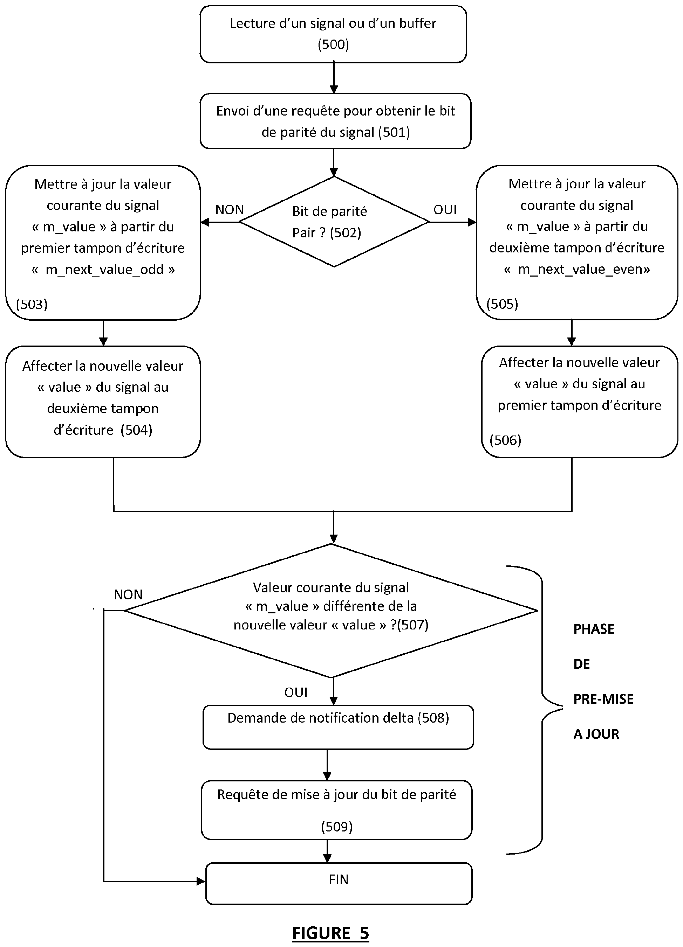

La figure 5 est un organigramme représentant les différentes étapes mises en oeuvre par la deuxième fonction de mise à jour 331 pour mettre à jour un signal lors de l'évaluation d'un processus qui écrit sur le signal.

L'écriture d'un signal commence également par la mise à jour de la valeur courante, contrairement à la phase de mise à jour classique. La mise à jour d'un signal selon l'invention est également réalisée pendant la phase d'évaluation, au moyen de la deuxième fonction de mise à jour 331, ce qui permet la parallélisation de la phase de mise à jour. Une fois la mise à jour effectuée, la nouvelle valeur est écrite dans l'un des deux tampons d'écriture qui n'a pas été utilisé pour la lecture. En cas d'écriture d'une nouvelle valeur, une demande de notification delta est générée pour évaluer les processus sensibles sur le signal. Une demande de mise à jour du bit de parité est ensuite envoyée au module matériel 32.

Lors de l'écriture (étape 500) d'un signal pouvant intervenir lors de la phase d'évaluation, une requête « *get_signal_parity()* » est envoyée au module matériel 32 pour obtenir le bit de parité courant du signal à l'étape 501. L'étape 502 détermine si le bit de parité courant reçu du module matériel 32 est pair. Si le bit de parité courant est pair, à l'étape 503, la valeur courante *m_value* du signal est mise à jour depuis la valeur *m_next value_even* du premier tampon d'écriture (ou tampon paire) : *« m_value* = *m_next value_even »*.

A l'étape 504, la nouvelle valeur du signal notée *« value »* est écrite dans le deuxième tampon d'écriture *m_next_value_odd* (tampon impair):
« *m_next_value_odd*=*value*».

Inversement, si le bit de parité courant est impair, la valeur courante *m_value* du signal est mise à jour à l'étape 505 depuis la valeur *m_next_value_odd* du deuxième tampon d'écriture (tampon impair) : « *m_value = m_next value_odd*».

La nouvelle valeur du signal est écrite dans le premier tampon d'écriture (tampon pair) *m_next value_even* à l'étape 506 : « *m_next_value_even = value »*.

A l'étape 507, il est déterminé si la nouvelle valeur du signal est différente de la valeur courante dudit signal : « *value != m_value »*.

Si la nouvelle valeur du signal est différente de sa valeur courante, une demande de notification delta est envoyée à l'étape 508 afin que l'évaluation des processus SystemC sensibles à ce signal soit demandée.

A l'étape 509, une demande de modification du bit de parité est envoyée au module matériel 32 au moyen de la requête de mise à jour *« push_update_request() »*. L'identifiant du signal *m_signal_id* est passé en paramètre de cette requête de mise à jour. Le module matériel 32 utilise l'identifiant du signal pour mettre à jour le bit de parité. La mise à jour du bit de parité est réalisée dans le module matériel 32 sur demande de l'ordonnanceur 31. Dans une forme de réalisation préférée de l'invention, la mise à jour d'un bit de parité consiste à inverser sa valeur : un bit pair devient impair, et un bit impair devient pair.

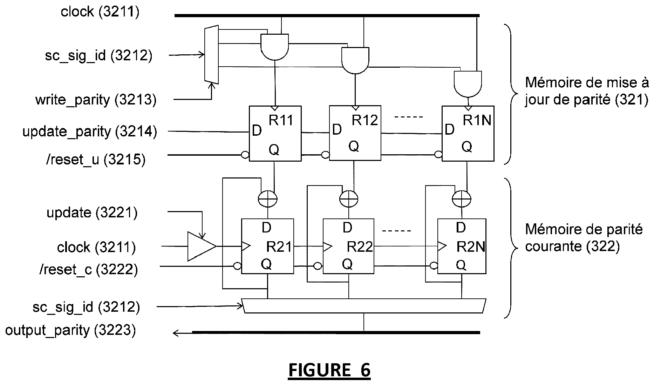

La figure 6 représente une forme de réalisation du module matériel 32, selon l'invention. Le module matériel 32 comprend un compteur (non représenté), ainsi qu'un premier bloc de mémorisation pour la mise à jour de parité 321 et un deuxième bloc de mémorisation pour la mise à jour de la parité courante 323.

Le module matériel 32 a notamment pour fonction d'inverser les bits de parité des signaux ayant été modifiés lors de la phase d'évaluation. De manière plus générale, il permet de gérer la mise à jour de la sélection d'un des deux tampons d'écriture.

Le compteur est agencé pour retourner des identifiants uniques en réponse aux requêtes « *get_update_signal_id()* » envoyées par l'ordonnanceur 31 lors de l'initialisation des signaux.

Le premier bloc de mémorisation 321, également appelé mémoire de mise à jour de parité, est agencé pour mettre à jour le bit de parité d'un signal, en réponse à une requête « *push_update_request()* » identifiant ce signal. Le deuxième bloc de mémorisation 322, également appelé mémoire de parité courante, est agencé pour déterminer le bit de parité courant d'un signal en réponse à une requête « *get_signal_parity()* » identifiant ce signal, et pour retourner ce bit courant.

Le premier bloc de mémorisation 321 peut être composé d'une série de N registres R11, R12, ...etc., R1N. De même, le deuxième bloc de mémorisation 322 peut être composé d'une série de N registres R21, R22, ...etc., R2N. Dans la forme de réalisation représentée sur la figure 6, le nombre de registres dans les deux blocs de mémorisation 321 et 322 est égal, et les registres sont indépendants entre eux. Par ailleurs, à chaque signal correspond un ensemble de deux registres R1i et R2i. Les deux registres R1i et R2i associés à un signal donné sont reliés entre eux de telle sorte que la sortie Q du registre R1i est reliée à l'entrée D du registre R2i. En particulier, le nombre total de signaux pouvant être instancié est égal au nombre de registres N pour chacun des blocs de mémorisation 322 et 321.

Avantageusement, à l'initialisation, le module matériel de mise à jour 32 initialise le contenu des registres R1i et R2i à 0 via deux signaux de commande de réinitialisation «/*reset_c*» (3222) et «/*reset_u*» (3215) associés respectivement aux blocs de mémorisation 321 et 322.

En réponse à la réception d'une requête « *get_signal_parity()* », envoyée par la deuxième fonction de mise à jour 331, la mémoire de parité courante 322 retourne la valeur courante de parité du signal. Pour cela, un paramètre « *sc_sig_id »* (3212) est donné en paramètre de la requête. Ce paramètre « *sc_sig_id* » représente l'identifiant unique d'un signal qui a été obtenu lors de l'initialisation par la fonction de mise à jour 311. Le paramètre « *sc_sig_id »* (3212) vient alors sélectionner la bonne colonne dans la mémoire de parité courante 322, ou encore le registre R2i associé audit signal. Le résultat du contenu du registre R2i sélectionné du deux bloc de mémorisation 322, encore appelé mémoire de parité courante, est alors présent sur la sortie « *output_parity* » (3223). Il est enfin renvoyé à la fonction de mise à jour (331).

En réponse à la réception d'une requête « *push_update_request()* », envoyée par la fonction de mise à jour (331), la valeur logique 1 est écrite dans le registre R1i correspondant audit signal de la mémoire de mise à jour de parité 321. Pour cela, un paramètre « *sc_sig_id »* (3212) représentant l'identifiant unique d'un signal, obtenu lors de l'initialisation par la fonction de mise à jour (311), est donné en paramètre de la requête. Ce paramètre « *sc_sig_id* » (3212) vient sélectionner la bonne colonne dans la mémoire de mise à jour de la parité 321, ou encore le registre R1i associé au signal. Un signal de contrôle, désigné par « *write_parity* » (3213), est prévu pour contrôler l'écriture du bit de parité dans le register R1i sélectionné par l'identifiant unique du signal. En réponse à la réception de la requête, le signal de contrôle « *write_parity* » (3213) est mis à 1. Sensiblement en même temps, le signal de mise à jour du bit de parité désigné par « *update_parity* » (3214) est également mis à 1. La mise à 1 de ces deux signaux de contrôle (3213) et (3214) a pour effet d'écrire la valeur logique 1 dans le registre R1i sélectionné de la mémoire de mise à jour de parité (321).

Lors de la phase de mise à jour, l'ordonnanceur 31 envoie une requête « *update* » au module matériel 32, ce qui a pour effet d'écrire sur le signal de contrôle « *update* » (3221) la valeur logique 1. La mise à 1 du signal « *update »* (3221) a pour effet de faire en parallèle un « OU exclusif » des contenus des registres d'une même colonne des mémoires de mise à jour de parité 321 et de parité courante 322, c'est-à-dire un « OU exclusif » entre les registres R1i et R2i. Ainsi, si la valeur du registre R1i de la mémoire de mise à jour de la parité 321 est à 1, la valeur du registre R2i de la mémoire de parité courante 322 est inversée : elle devient égale à 0 si elle était à 1, et devient égale à 1 si elle était égale à 0. Au contraire, si la valeur du registre R1i de la mémoire de mise à jour de la parité 321 est à 0, le contenu du registre R2i de la mémoire de parité courante 322 est inchangé.

Ainsi, l'activation du signal «update» (3221) permet en quelques cycles de changer la parité courante de tous les signaux SystemC dont la valeur a été modifiée pendant la phase d'évaluation 210. Le noyau de simulation selon l'invention permet ainsi une mise à jour, en un temps très court, des bits de parité des signaux SystemC modifiés lors des phases d'évaluation. Cela contribue à réduire fortement le temps de simulation. L'utilisation disjointe de deux mémoires, l'une pour stocker les demandes de mises à jour du bit de parité, l'autre pour stocker les valeurs courantes des bits de parité, permet en outre une évaluation parallèle de la phase de mise à jour et permet d'assurer que la valeur de parité courante ne sera modifiée qu'après la phase de mise à jour. Enfin l'utilisation d'éléments logiques élémentaires (registre, porte «OU exclusif »...) garantit une très faible complexité et surface matérielle.

En accélérant de manière significative le noyau systemC, l'invention permet d'augmenter les performances pour la vérification fonctionnelle, l'exploration architecturale, le partitionnement logiciel/matériel, la validation des applications, et plus généralement pour la conception des systèmes complexes.

Ces avantages sont encore plus significatifs lorsque les simulations sont exécutées par des calculateurs capables de supporter efficacement une exécution parallèle des processus SystemC. De nombreuses avancées sont en cours dans ce domaine. Conjugué à des fonctions de parallélisation des processus, le noyau SystemC selon l'invention permet de repousser les limites actuelles d'utilisation des outils logiciels de prototypage tout en conservant une précision importante, y compris dans le développement applicatif. Par ailleurs, il permet d'accélérer sensiblement l'exploration architecturale, rendant ainsi possible de plus importantes optimisations dans un temps de conception identique.

L'invention a été décrite en relation avec la mise à jour d'un élément de liaison du systemC de type signal ou «buffer», à titre d'exemple non limitatif. Elle s'applique de manière similaire à la mise à jour de tout élément de liaison nécessitant une mise à jour après évaluation, comme par exemple tout canal combinant des signaux ou des «buffers», ou encore sur les ports utilisés pour connectés des modules entre eux. Plus généralement, l'invention s'applique de manière identique à tout langage de description matérielle autre que SystemC qui nécessite une étape de mise à jour des éléments de sa grammaire seulement après la fin de la phase d'évaluation ( phase contenant les lectures et écritures de ces éléments).

L'invention n'est pas limitée aux modes de réalisation décrits ci-avant à titre d'exemple non limitatif. Elle englobe toutes les variantes de réalisation qui pourront être envisagées par l'homme du métier. En particulier, bien que l'invention présente certains avantages pour un mot de sélection de type bit de parité, elle s'applique à tout type d'élément de sélection comme par exemple un mot de plusieurs bits (e.g. 16 ou 32 bits). L'invention n'est pas non plus limitée à l'agencement d'éléments logiques représenté sur la figure 6. Par ailleurs, le module matériel de mise à jour 32 a été décrit comme un élément additionnel de l'architecture. En variante, il peut être intégré dans le gestionnaire mémoire de l'architecture, élément existant dans tout calculateur nécessitant une gestion dynamique de la mémoire.

## Revendications

1. Procédé pour accélérer une simulation d'un système généré selon un langage de description matérielle donné, ledit procédé comprenant une phase d'évaluation d'un noyau de simulation dudit langage de description matérielle, ladite phase d'évaluation (210) comprenant des accès en écriture ou en lecture (400, 500) à des éléments de liaison du langage de description matérielle, deux emplacements mémoires d'écriture étant prévus au préalable pour chacun des éléments de liaison, **caractérisé en ce que** ladite phase d'évaluation comprend une mise à jour d'un élément de liaison du langage de description matérielle, pour chaque accès en écriture ou en lecture dudit élément de liaison, ladite mise à jour comprenant les étapes suivantes :
- recevoir un mot de sélection associé audit élément de liaison (401, 501) ;
- sélectionner l'un des deux emplacements d'écriture associés audit élément de liaison en fonction de la valeur du mot de sélection reçu pour ledit élément de liaison ; et
- mettre à jour la valeur courante dudit élément de liaison à partir de l'emplacement mémoire d'écriture sélectionné (403, 404, 503, 505).

2. Procédé selon la revendication 1, **caractérisé en ce que** le mot de sélection est un bit de parité.

3. Procédé selon l'une des revendications précédentes, **caractérisé en ce que** la mise à jour des éléments de liaison est effectuée en parallèle lors de la phase d'évaluation.

4. Procédé selon l'une des revendications précédentes, **caractérisé en ce qu'**il comprend des demandes de changement d'état des mots de sélection associés aux éléments de liaison, lesdites demandes étant effectuées en parallèle pendant la phase d'évaluation.

5. Procédé selon l'une des revendications précédentes, **caractérisé en ce que** les mots de sélection associé aux éléments de liaison restent constants pendant la phase d'évaluation

6. Procédé selon l'une des revendications précédentes, **caractérisé en ce que** pour un accès à un élément de liaison de type lecture, la mise à jour de l'élément de liaison comprend les étapes suivantes :
- recevoir la valeur du mot de sélection pour l'élément de liaison (402),
- mettre à jour (403, 404) la valeur courante de l'élément de liaison depuis un emplacement mémoire d'écriture déterminé selon la valeur du mot de sélection reçu, et
- retourner la nouvelle valeur courante (405).

7. Procédé selon l'une des revendications précédentes, **caractérisé en ce que** pour un accès à un élément de liaison de type écriture, l'étape de mise à jour dudit élément de liaison comprend les étapes suivantes :
- recevoir la valeur du mot de sélection pour l'élément de liaison (502),
- mettre à jour (503 et 505) la valeur courante de l'élément de liaison depuis un emplacement mémoire d'écriture déterminé selon la valeur du mot de sélection reçu,
- écrire (505 et 506) la nouvelle valeur de l'élément de liaison dans 1' emplacement mémoire d'écriture distinct de l'emplacement mémoire d'écriture déterminé selon la valeur du mot de sélection reçu.

8. Procédé selon la revendication 7, **caractérisé en ce qu'**il comprend en outre une demande de notification delta (508) pour l'évaluation des processus sensibles sur ledit élément de liaison si la nouvelle valeur de 1' élément de liaison est différente de la valeur courante de l'élément de liaison (507).

9. Procédé selon l'une des revendications 7 et 8, **caractérisé en ce qu'**il comprend en outre l'émission d'une requête de mise à jour du mot de sélection associé audit élément de liaison (509).

10. Procédé selon l'une des revendications précédentes, **caractérisé en ce que** l'étape de mise à jour du mot de sélection comprend une mise à jour du mot de sélection à une valeur opposée à celle du mot de sélection.

11. Procédé selon l'une des revendications précédentes, **caractérisé en ce que** le langage de description matérielle est SystemC.

12. Procédé selon la revendication 11, **caractérisé en ce que** les éléments de liaison comprennent l'un au moins parmi les éléments SystemC suivants : des signaux « sc_signal », des signaux « sc_signal_resolved », des signaux « sc_signal_rv », des mémoires tampons « sc_buffer ».

13. Dispositif pour accélérer une simulation d'un système généré selon un langage de description matérielle donné, ledit dispositif comprenant une unité d'évaluation (33) pour l'exécution d'une phase d'évaluation d'un noyau de simulation dudit langage de description matérielle, ladite phase d'évaluation comprenant des accès en écriture ou en lecture d'éléments de liaison du langage de description matérielle, le dispositif comprenant deux emplacements mémoires d'écriture pour chacun des éléments de liaison, **caractérisé en ce que** l'unité d'évaluation comprend en outre, en réponse à un accès en lecture ou en écriture d'un élément de liaison du langage de description matérielle, un appel à une fonction de mise à jour (331) apte à mettre à jour ledit élément de liaison, ladite fonction de mise à jour étant configurée pour :
- recevoir un mot de sélection associé audit élément de liaison à modifier ;
- sélectionner l'un des deux emplacements d'écriture associés audit élément de liaison en fonction de la valeur du mot de sélection reçu pour ledit élément de liaison ; et
- mettre à jour la valeur courante dudit élément de liaison à partir de l'emplacement mémoire d'écriture sélectionné.

14. Dispositif selon la revendication 13, **caractérisé en ce qu'**il comprend un module matériel (32) agencé pour délivrer le mot de sélection associé à chaque élément de liaison et pour mettre à jour les mots de sélection.

## Patentansprüche

1. Verfahren zum Beschleunigen einer Simulation eines gemäß einer gegebenen Hardware-Beschreibungssprache erzeugten Systems, wobei das Verfahren eine Phase des Beurteilens eines Simulationskerns der Hardware-Beschreibungssprache beinhaltet, wobei die Beurteilungsphase (210) Schreib- oder Lesezugriffe (400, 500) auf Verbindungselemente der Hardware-Beschreibungssprache beinhaltet, wobei für jedes der Verbindungselemente zwei Schreibspeicherorte im Voraus bereitgestellt werden, **dadurch gekennzeichnet, dass** die Beurteilungsphase das Aktualisieren eines Verbindungselements der Hardware-Beschreibungssprache für jeden Schreib- oder Lesezugriff des Verbindungselements beinhaltet, wobei das Aktualisieren die folgenden Schritte beinhaltet:
- Empfangen eines mit dem Verbindungselement (401, 501) assoziierten Auswahlwortes;
- Auswählen eines der beiden mit dem Verbindungselement assoziierten Schreiborte in Abhängigkeit vom Wert des für das Verbindungselement empfangenen Auswahlworts; und
- Aktualisieren des aktuellen Werts des Verbindungselements auf der Basis des gewählten Schreibspeicherorts (403, 404, 503, 505).

2. Verfahren nach Anspruch 1, **dadurch gekennzeichnet, dass** das Auswahlwort ein Paritätsbit ist.

3. Verfahren nach einem der vorherigen Ansprüche, **dadurch gekennzeichnet, dass** das Aktualisieren der Verbindungselemente parallel während der Beurteilungsphase durchgeführt wird.

4. Verfahren nach einem der vorherigen Ansprüche, **dadurch gekennzeichnet, dass** es Anfragen zum Ändern des Zustands der mit den Verbindungselementen assoziierten Auswahlwörter beinhaltet, wobei die Anfragen parallel während der Beurteilungsphase durchgeführt werden.

5. Verfahren nach einem der vorherigen Ansprüche, **dadurch gekennzeichnet, dass** die mit den Verbindungselementen assoziierten Auswahlwörter während der Beurteilungsphase konstant bleiben.

6. Verfahren nach einem der vorherigen Ansprüche, **dadurch gekennzeichnet, dass** das Aktualisieren des Verbindungselements für einen Lesezugriff auf ein Verbindungselement die folgenden Schritte beinhaltet:
- Empfangen des Wertes des Auswahlworts für das Verbindungselement (402);
- Aktualisieren (403, 404) des aktuellen Werts des Verbindungselements von einem gemäß dem Wert des empfangenen Auswahlworts bestimmten Schreibspeicherort; und
- Zurückgeben des neuen aktuellen Werts (405).

7. Verfahren nach einem der vorherigen Ansprüche, **dadurch gekennzeichnet, dass** der Schritt des Aktualisierens des Verbindungselements für einen Schreibzugriff auf ein Verbindungselement die folgenden Schritte beinhaltet:
- Empfangen des Werts des Auswahlworts für das Verbindungselement (502);
- Aktualisieren (503 und 505) des aktuellen Werts des Verbindungselements von einem gemäß dem Wert des empfangenen Auswahlworts bestimmten Schreibspeicherort;
- Schreiben (505 und 506) des neuen Werts des Verbindungselements in dem Schreibspeicherort getrennt von dem gemäß dem Wert des empfangenen Auswahlworts bestimmten Schreibspeicherort.

8. Verfahren nach Anspruch 7, **dadurch gekennzeichnet, dass** es ferner eine Delta-Benachrichtigungsanfrage (508) zum Beurteilen von empfindlichen Prozessen an dem Verbindungselement beinhaltet, wenn sich der neue Wert des Verbindungselements vom aktuellen Wert des Verbindungselements (507) unterscheidet.

9. Verfahren nach einem der Ansprüche 7 bis 8, **dadurch gekennzeichnet, dass** es ferner das Senden einer Anforderung zum Aktualisieren des mit dem Verbindungselement (509) assoziierten Auswahlworts beinhaltet.

10. Verfahren nach einem der vorherigen Ansprüche, **dadurch gekennzeichnet, dass** der Schritt des Aktualisierens des Auswahlworts das Aktualisieren des Auswahlworts auf einen Wert entgegengesetzt zu dem des Auswahlworts beinhaltet.

11. Verfahren nach einem der vorherigen Ansprüche, **dadurch gekennzeichnet, dass** die Hardware-Beschreibungssprache SystemC ist.

12. Verfahren nach Anspruch 11, **dadurch gekennzeichnet, dass** die Verbindungselemente wenigstens eines der folgenden SystemC-Elemente beinhalten: "sc_signal"-Signale, "sc_signal_resolved"-Signale, "sc_signal_rv"-Signale, "sc_buffer"-Pufferspeicher.

13. Vorrichtung zum Beschleunigen einer Simulation eines gemäß einer gegebenen Hardware-Beschreibungssprache erzeugten Systems, wobei die Vorrichtung eine Beurteilungseinheit (33) zum Ausführen einer Phase des Beurteilens eines Simulationskerns der Hardware-Beschreibungssprache umfasst, wobei die Beurteilungsphase Schreib- oder Lesezugriffe der Verbindungselemente der Hardware-Beschreibungssprache beinhaltet, wobei die Vorrichtung zwei Schreibspeicherorte für jedes der Verbindungselemente umfasst, **dadurch gekennzeichnet, dass** die Beurteilungseinheit ferner, als Reaktion auf einen Lese- oder Schreibzugriff eines Verbindungselements der Hardware-Beschreibungssprache, einen Anruf an eine Aktualisierungsfunktion (331) umfasst, die das Verbindungselement aktualisieren kann, wobei die Aktualisierungsfunktion konfiguriert ist zum:
- Empfangen eines mit dem zu modifizierenden Verbindungselement assoziierten Auswahlworts;
- Auswählen wenigstens eines der beiden mit dem Verbindungselement assoziierten Schreiborte in Abhängigkeit vom Wert des für das Verbindungselement empfangenen Auswahlworts; und
- Aktualisieren des aktuellen Wertes des Verbindungselements auf der Basis des gewählten Speicherschreiborts.

14. Vorrichtung nach Anspruch 13, **dadurch gekennzeichnet, dass** sie ein Hardware-Modul (32) zum Liefern des mit jedem Verbindungselement assoziierten Auswahlworts und zum Aktualisieren der Auswahlwörter umfasst.

## Claims

1. A method for accelerating a simulation of a system generated according to a given hardware description language, said method comprising a phase of evaluating a simulation kernel of said hardware description language, said evaluation phase (210) comprising write or read accesses (400, 500) to linking elements of said hardware description language, with two write memory locations being previously provided for each of said linking elements, **characterised in that** said evaluation phase comprises updating a linking element of said hardware description language, for each write or read access of said linking element, said updating comprising the following steps:
- receiving a selection word associated with said linking element (401, 501);
- selecting one of the two write locations associated with said linking element according to the value of the selection word received for said linking element; and
- updating the current value of said linking element on the basis of the selected write memory location (403, 404, 503, 505).

2. The method according to claim 1, **characterised in that** the selection word is a parity bit.

3. The method according to any one of the preceding claims, **characterised in that** updating said linking elements is carried out in parallel during said evaluation phase.

4. The method according to any one of the preceding claims, **characterised in that** it comprises requests for changing the state of the selection words associated with said linking elements, said requests being carried out in parallel during said evaluation phase.

5. The method according to any one of the preceding claims, **characterised in that** the selection words associated with said linking elements remain constant during said evaluation phase.

6. The method according to any one of the preceding claims, **characterised in that** for a read access to a linking element, updating said linking element comprises the following steps:
- receiving the value of the selection word for said linking element (402);
- updating (403, 404) the current value of said linking element from a write memory location determined according to the value of the received selection word; and
- feeding back the new current value (405).

7. The method according to any one of the preceding claims, **characterised in that**, for a write access to a linking element, the step of updating said linking element comprises the following steps:
- receiving the value of the selection word for said linking element (502);
- updating (503 and 505) the current value of said linking element from a write memory location determined according to the value of the received selection word;
- writing (505 and 506) the new value of said linking element in the write memory location distinct from the write memory location determined according to the value of the received selected word.

8. The method according to claim 7, **characterised in that** it further comprises a delta notification request (508) for evaluating sensitive processes on said linking element if the new value of said linking element is different to the current value of said linking element (507).

9. The method according to any one of claims 7 to 8, **characterised in that** it further comprises the emission of a request for updating the selection word associated with said linking element (509).

10. The method according to any one of the preceding claims, **characterised in that** said step of updating the selection word comprises updating the selection word to a value opposite to that of the selection word.

11. The method according to any one of the preceding claims, **characterised in that** said hardware description language is SystemC.

12. The method according to claim 11, **characterised in that** said linking elements comprise at least one of the following SystemC elements: "sc_signal" signals, "sc_signal_resolved" signals, "sc_signal_rv" signals, "sc_buffer" buffer memories.

13. A device for accelerating a simulation of a system generated according to a given hardware description language, said device comprising an evaluation unit (33) for executing a phase of evaluating a simulation kernel of said hardware description language, said evaluation phase comprising write or read accesses of linking elements of said hardware description language, said device comprising two write memory locations for each of said linking elements, **characterised in that** said evaluation unit further comprises, in response to a read or write access of a linking element of said hardware description language, a call to an updating function (331) that can update said linking element, said updating function being configured to:
- receive a selection word associated with said linking element to be modified;
- select one of the two write locations associated with said linking element according to the value of the selection word received for said linking element; and
- update the current value of said linking element on the basis of the selected write memory location.

14. The device according to claim 13, **characterised in that** it comprises a hardware module (32) arranged to deliver the selection word associated with each linking element and to update the selection words.
